# EUROPEAN PATENT APPLICATION

(11) **EP 2 055 397 A2**
(43) Date of publication of application: **06.05.2009**
(21) Application number: 08168111.6
(22) Date of filing: 31.10.2008
(51) Int. Cl.: B08B 7/00, H01L 21/00, H01J 37/32, C23C 16/44

(54) **In-situ chamber cleaning method**

(30) Priority: 02.11.2007 US 934328
(71) Applicant: Applied Materials, Inc., Santa Clara, CA 95054 (US)
(72) Inventor: Kojiri, Hidehiro, Sunnyvale, CA 94086 (US)
(74) Representative: Zimmermann & Partner

(57) **Abstract**

An in-situ chamber cleaning method is performed in a chamber having a gas-distributing member, wherein the gas-distributing member comprises a plurality of apertures. A cleaning gas flow is provided through some of the apertures into the chamber while no cleaning gas flow is provided through the remaining apertures. The cleaning gas flow is ionized such that ionized cleaning gas radicals are used to clean the chamber.

## Description

### Field

Embodiments of the present invention relate generally to a cleaning method. More specifically, the embodiments relate to an in-situ cleaning method for a semiconductor-manufacturing chamber. Further the present invention is related to a semiconductor process.

### Background

Primary processes in the fabrication of modern semiconductor devices are formation and etching of thin films on a semiconductor substrate by chemical reaction of gases. No matter which fabrication process of formation and etching thin films is performed, particle contamination within the chamber is nearly unavoidable.

Particle contamination within the chamber is typically controlled by periodically cleaning the chamber using cleaning gases that are excited to inductively or capacitively coupled plasmas. Cleaning gases are selected based on their ability to bind the precursor gases and a deposited material that has formed on the chamber components in order to form stable volatile products which can be exhausted from the chamber, thereby cleaning the process environment.

While in-situ chamber cleaning has been developed in reducing most contaminants in a plasma reactor, contaminants under some circumstances have still been measured above desired levels. Therefore, there exists a need for an improved conventional in-situ chamber cleaning method for further reducing contaminants within a plasma reactor.

### Summary

In light of the above, the in-situ chamber cleaning method according to independent claim 1, the in-situ chamber cleaning method according to independent claim 6, and the semiconductor process are provided.

Further advantages, features, aspects and details are evident from the dependent claims, the description and the drawings.

According to one embodiment of the present invention, an in-situ chamber cleaning method is performed in a chamber having a gas-distributing member, wherein the gas-distributing member comprises a plurality of apertures. A cleaning gas flow is provided through some of the apertures into the chamber while less cleaning gas flow is provided through the remaining apertures. The cleaning gas flow is ionized such that ionized cleaning gas radicals are used to clean the chamber.

In another embodiment, an in-situ chamber cleaning method is performed in a chamber having a gas-distributing member, wherein the gas-distributing member comprises a plurality of apertures. A cleaning gas flow is provided through a first group of the apertures into the chamber while no cleaning gas flow is provided through the remaining second group of the apertures to at least partially clean the first group of apertures. After the first group of apertures has been at least partially cleaned, a cleaning gas flow is provided through the second group of the apertures into the chamber while no cleaning gas flow is provided through the first group of the apertures to at least partially clean the second group of apertures. The cleaning gas flow is ionized such that ionized cleaning gas radicals are used to clean the chamber.

In still another embodiment, a semiconductor process is provided. Semiconductor wafers are serially processed in a chamber and a gas-distributing member inside the chamber is used to introduce a processing gas flow, wherein the gas-distributing member comprises a plurality of apertures. An in-situ chamber cleaning is conducted after processing a predefined number semiconductor wafers by using the gas-distributing member to introduce a cleaning gas. The cleaning gas is introduced such that when the cleaning gas flows through a first group of apertures into the chamber, there is no cleaning gas that flows through the remaining second group of apertures. And, when the cleaning gas flows through the second group of apertures into the chamber, there is no cleaning gas flows through the first group of apertures. The cleaning gas flow is ionized such that ionized cleaning gas radicals are used to clean the chamber.

In a further embodiment, an in-situ chamber cleaning method is performed in a chamber having a gas-distributing member, wherein the gas-distributing member comprises a plurality of apertures. A cleaning gas flow is provided through some of the apertures into the chamber while no cleaning gas flow is provided through the remaining apertures. The cleaning gas flow is ionized such that ionized cleaning gas radicals are used to clean the chamber.

An embodiment is further directed to a chamber having a gas-distributing member, wherein the gas-distributing member comprises a plurality of apertures.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### Brief Description of the Drawings

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.

Figure 1 illustrates a bottom view of a gas-distributing member as described in an embodiment herein.

Figure 2 illustrates how contaminants around gas aperture are not properly cleaned using conventional cleaning process.

Figure 3 and Figure4 respectively illustrate mechanisms to clean gas apertures as described in an embodiment herein.

Figure 5 illustrates a flowchart of an in-situ chamber cleaning method as described in an embodiment herein.

Figure 6 illustrates another flowchart of an in-situ chamber cleaning method as described in an embodiment herein.

### Detailed Description

Embodiments as described herein are generally directed to an improved in-situ chamber cleaning method. Embodiments of the present invention can be used to clean a plasma processing chamber, for example.

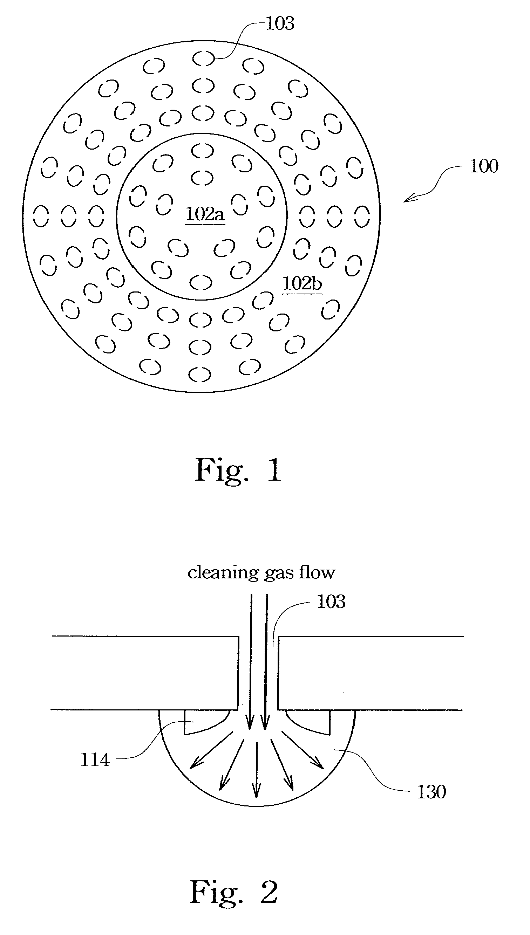

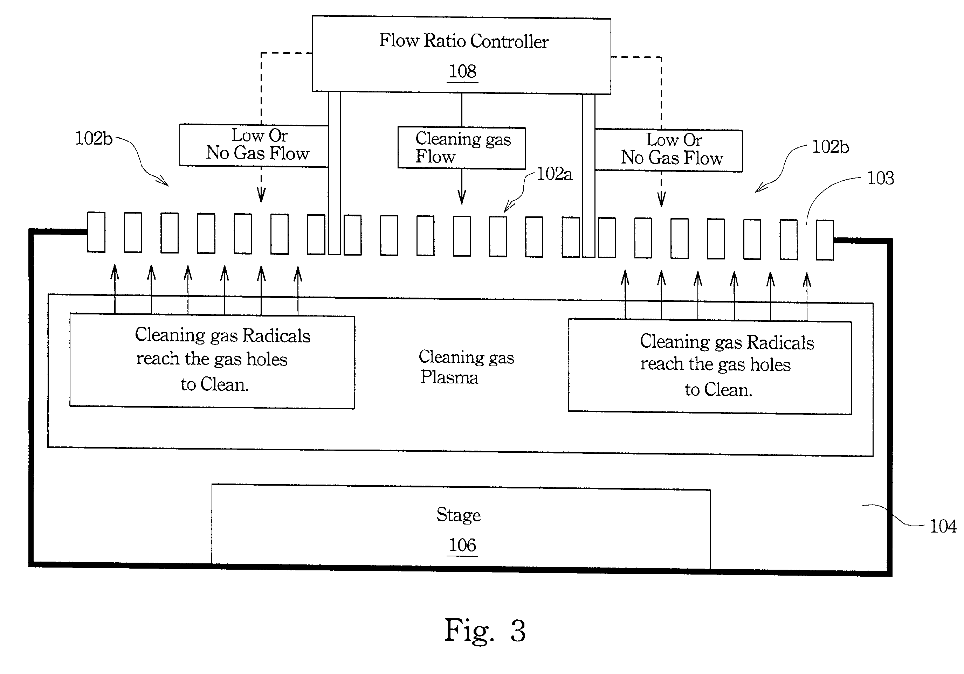

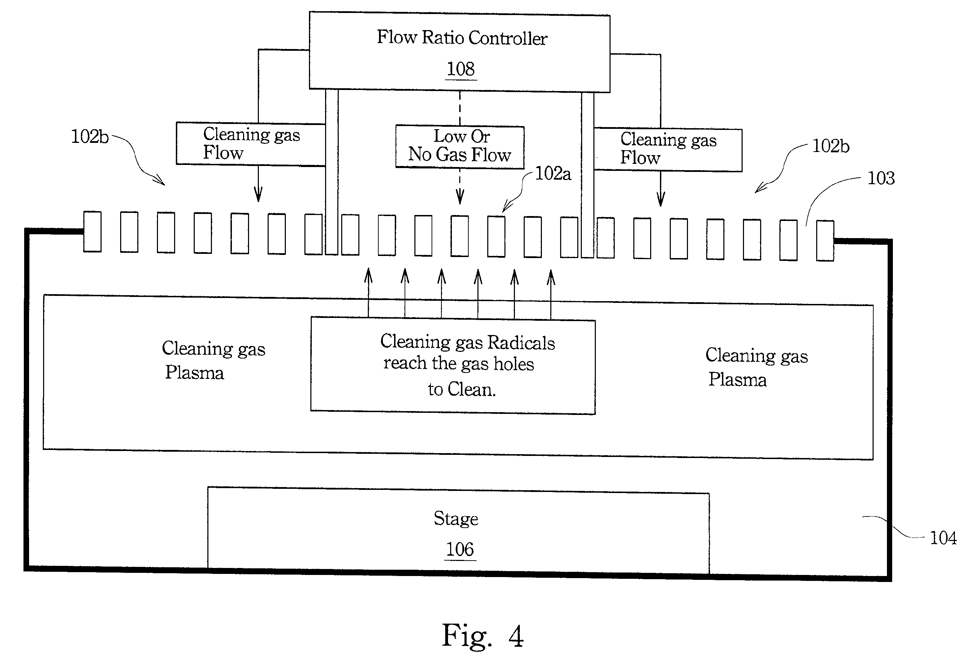

Figure 1 illustrates a bottom view of a gas-distributing member as described in an embodiment herein. A process chamber in this embodiment is equipped with a plasma-generating RF power (not illustrated in drawings) and a gas-distributing member 100, which has a circular bottom area. A central circular zone 102a and an outer zone 102b, which encircles the central circular zone 102a, are on the circular bottom area of the gas-distributing member 100. Both the central circular zone 102a and the outer zone 102b are full of gas flow apertures 103 (such as circular C-shaped slits or other suitable shape). Process gases or cleaning gases are introduced through the gas-distributing member 100 (through the apertures 103 thereof) into the process chamber (illustrated in Figure 3 and Figure 4). The gas-distributing member 100 can be a spray nozzle or showerhead. The plasma-generating RF power ionizes process gases or cleaning gases such that those ionized gases (also referred to as plasma) can perform their desired functions, e.g., etching thin films or cleaning contaminants or particles.

In a monitored etching process, semiconductor wafers were serially processed (e.g., etched) in a chamber and a gas-distributing member. In one embodiment, the gas-distributing member 100, inside the chamber is used to introduce a processing gas flow. Under a current practice, a conventional chamber cleaning process would be conducted after processing a predetermined number of semiconductor wafers by using the gas-distributing member 100 wherein a cleaning gas is introduced through all gas flow apertures 103 into the process chamber (Figure 2). Such conventional cleaning processes leave contaminants around the gas apertures. It is believed that particles or contaminants 114 immediately around the apertures 103 are not properly cleaned because of the cleaning gas flow through the apertures 103 creates a high pressure zone 130 immediately around the apertures 103 which prevents the cleaning plasma from effectively reaching, attacking and removing such particles or contaminants 114.

Figure 3 and Figure 4 respectively illustrate mechanisms used serially to clean the flow apertures 103 as described in an embodiment herein. Embodiments described herein employ a serial mechanism as illustrated in Figure 3 and Figure 4 to clean immediate areas

In one embodiment, as illustrated in Figure 3, cleaning gas flows are introduced through the apertures 103 of the central circular zone 102a while no gas flow is provided through the apertures 103 of the outer zone 102b under control of a flow ratio controller 108. Optionally, some gas flow may be provided through the apertures 103 of the outer zone 102b which is less than the flow provided through the apertures 103 of the central circular zone 102a. The rate of lesser flow is generally selected such that a high pressure area present at the downstream side of the aperture 103 is sufficiently reduced in area such that the area around the aperture 103 is more efficiently cleaned. The cleaning gas, which has been introduced into the chamber 104 through the apertures 103 of the central circular zone 102a, is then ionized by a radio-frequency power. Because no gas is introduced through the apertures 103 of the outer zone 102b, high pressure is not generated immediately around the apertures 103 of the outer zone 102b. In one embodiment, ionized gas radicals attack and remove particles or contaminants immediately around the apertures 103 of the outer zone 102b.

Similarly, as illustrated in Figure 4, in one embodiment, cleaning gas flows are introduced through the apertures 103 of the outer zone 102b while no gas flow is provided through the apertures 103 of the central circular zone 102a under control of the flow ratio controller 108. The cleaning gas flows, which have been introduced into the chamber 104, are then ionized by radio-frequency power. Because gas flow is not introduced through the apertures 103 of the central circular zone 102a, high pressure is not generated immediately around the apertures 103 of the central circular zone 102a. In one embodiment, the ionized gas radicals attack and remove particles or contaminants immediately around the apertures 103 of the central circular zone 102a.

Cleaning mechanisms as illustrated in Figure 3 and Figure 4 are provided for effectively cleaning particles or contaminants immediately around the apertures 103. In one embodiment, semiconductor wafers are serially etched in a chamber and the gas-distributing member 100 is used to introduce processing gases and cleaning gases. An in-situ chamber cleaning method according to an embodiment of the present invention is conducted after processing a predetermined semiconductor wafers (such as between each wafer serially processed) by using the cleaning mechanisms as illustrated in Figure 3 and Figure 4. With the embodiments of the present invention, cluster particles or contaminants found on the processed semiconductor wafers, such as wafers etched on a stage 106 within the chamber 104, have been measured under desired levels. The elimination of the high pressure immediately around apertures according to embodiments of the present invention further allows the cleaning plasma to remove contaminants from the gas-distributing member.

In one embodiment, oxygen gases are used to clean carbon-based polymer residuals deposited on the bottom area of the gas-distributing member 100. Other gases, e.g. NF₃, CF₄, SF₆, Cl₂ or HBr can also be used to clean inorganic residuals like Si, Ti, Al, Cu etc. Other gases, e.g. N₂, H₂, H₂O, CH₃OH can also be used to clean carbon-based polymer residuals.

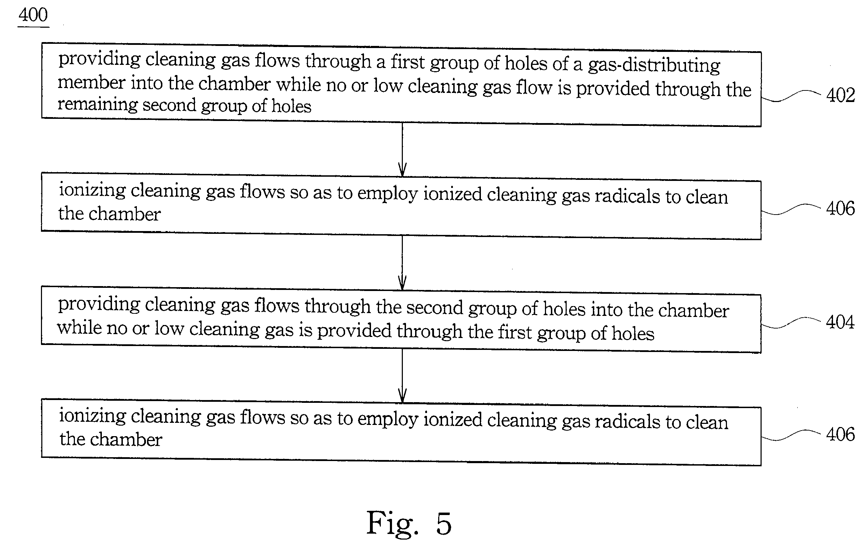

Figure 5 illustrates a flowchart of an in-situ chamber cleaning method 400 as described in an embodiment herein. As illustrated in Figure 3 and Figure 4, cleaning gas flows are introduced through gas apertures of the outer zone 102b while no gas flow is provided through the gas apertures of the central circular zone 102a. It is to be appreciated that cleaning mechanisms are not limited in the shape of the central zone 102a or the outer zone 102b for cleaning deposited residuals around gas apertures. As described in block 402, a cleaning gas flow is provided through a first group of apertures of the gas-distributing member into the chamber while no cleaning gas flow is provided through the remaining second group of the apertures of the gas-distributing member. As described in block 404, a cleaning gas flow is provided through the second group of apertures of the gas-distributing member into the chamber while no cleaning gas flow is provided through the first group of apertures of the gas-distributing member. Either one of block 402 or block 404 can be conducted first before the other one. The introduced cleaning gas is ionized to produce cleaning gas radicals (block 406). In one embodiment, the process of block k 406 is conducted as soon as the cleaning gas flow is introduced into the chamber. In one embodiment, the ionized cleaning gas radicals clean deposited residuals around the apertures.

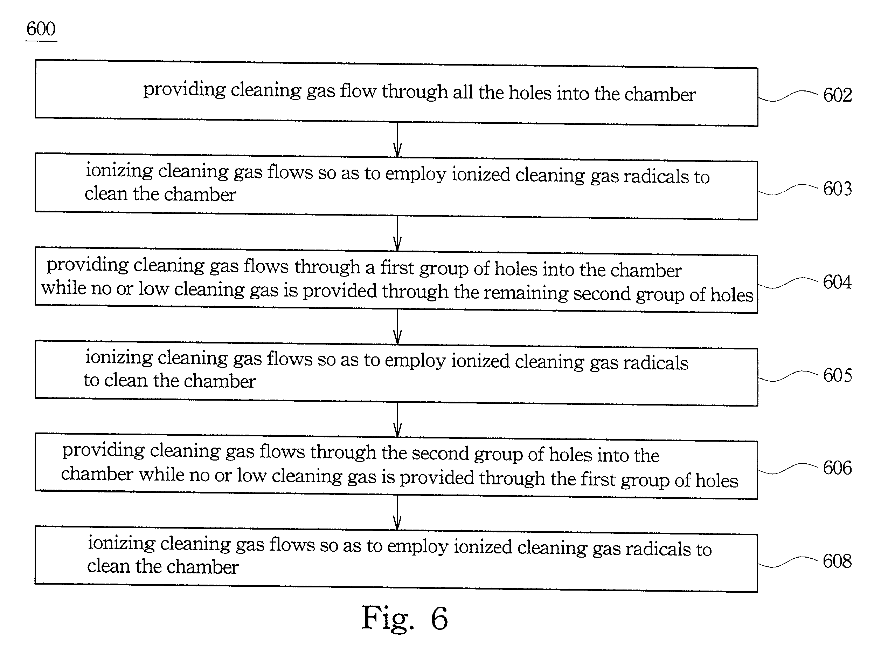

Figure 6 illustrates another flowchart of an in-situ chamber cleaning method as described in an embodiment herein. The cleaning method 400 can be further optimized as the cleaning method 600 by introducing and ionizing a cleaning gas through all of the apertures prior to performing the cleaning process described in method 400. As illustrated, at block 602, a cleaning gas is flown through all apertures in the chamber. At block 603, the introduced cleaning gas is ionized to clean the chamber. The addition of the cleaning gas at blocks 602 and 603 can be added prior to performing the cleaning method 400, and can be used to clean bulk contaminants within or around the gas apertures or within the chamber accompanied by applying larger gas input pressure than the pressure applied in block 604 or block 606. As described in block 604, a cleaning gas flow is provided through a first group of apertures of the gas-distributing member into the chamber while no cleaning gas flow is provided through the remaining second group of apertures of the gas-distributing member. The cleaning gas is ionized at block 605 to clean the chamber. As described in block 606 a cleaning gas flow is provided through the second group of apertures of the gas-distributing member into the chamber while no cleaning gas flow is provided through the first group of apertures of the gas-distributing member. The cleaning gas is ionized at block 608 to clean the chamber. Either one of block 604 or block 606 can be conducted first before the other one.

Introduction of the cleaning gas through all of the apertures as described at blocks 602 and 603 can be conducted before, after, or between the introduction of the cleaning gas only through the first group of apertures or only through the second group of apertures as described at blocks 604 and 606. In one embodiment, block 602 can be conducted once before block 604 and block 606, and once more after block 604 and block 606. In an alternate embodiment, block 602 can be conducted once before block 604 and block 606, and one more between block 604 and block 606. In different cases, block 602 can be conducted with block 604 and block 606 according to actual demands, and the sequence order or the duration of performing those blocks can also be varied according to actual demands.

According to the forgoing embodiments, the improved in-situ chamber cleaning methods provide an effective way to clean particles or contaminants immediately around the gas apertures of the gas-distributing member as well as other areas within the process chamber. It is contemplated in all of the embodiments above that when the main cleaning gas flow if provided through the first group of apertures, some gas flow may be provided through the second group of apertures, wherein the flow through the second group of apertures is less than the flow provided through the first group of apertures such that the high pressure area present at the downstream side of the second group of apertures is sufficiently reduced in area such that the area such that the second group of apertures is preferentially cleaned relative to the first group of apertures because of the lower pressure at the downstream side of the second group of apertures.

While the foregoing is directed to embodiments of the present invention, other and further embodiments of the invention may be devised without departing from the basic scope thereof, and the scope thereof is determined by the claims that follow.

## Claims

1. An in-situ chamber cleaning method, comprising:
in a chamber having a gas-distributing member, wherein the gas-distributing member comprises a plurality of apertures, providing a cleaning gas flow through some of the apertures into the chamber while no cleaning gas is provided through the remaining apertures; and
ionizing the cleaning gas flow so as to employ ionized cleaning gas radicals to clean the chamber.

2. The in-situ chamber cleaning method of claim 1, wherein the cleaning gas comprises oxygen.

3. The in-situ chamber cleaning method of claim 1 or 2, wherein the cleaning gas comprises at least one of oxygen, nitrogen, hydrogen, CF₄, NF₃, SF₆, Cl₂, HBr, H₂O or CH₃OH.

4. The in-situ chamber cleaning method of one of the claims 1 to 3, wherein the apertures are C-shaped silts.

5. The in-situ chamber cleaning method of one of the claims 1 to 4, wherein the gas-distributing member is a spray nozzle or showerhead.

6. An in-situ chamber cleaning method, comprising:
in a chamber having a gas-distributing member, wherein the gas-distributing member comprises a plurality of apertures, providing a cleaning gas flow through a first group of the apertures into the chamber while no cleaning gas is provided through the remaining second group of the apertures;
providing a cleaning gas flow through the second group of the apertures into the chamber while no cleaning gas flow through the first group of the apertures; and
ionizing the cleaning gas flow so as to employ ionized cleaning gas radicals to clean the chamber.

7. The in-situ chamber cleaning method of claim 6, wherein the apertures are C-shaped silts, a spray nozzle or a showerhead.

8. The in-situ chamber cleaning method of claim 6 or 7, wherein the cleaning gas comprises oxygen.

9. The in-situ chamber cleaning method of one of the claims 6 to 8, wherein the cleaning gas comprises at least one of nitrogen, hydrogen, CF₄, NF₃, SF₆, Cl₂, HBr, H₂O or CH₃OH.

10. The in-situ chamber cleaning method of one of the claims 6 to 9, wherein the gas-distributing member comprises a circular area, where the first group of the apertures are located in a central circular zone and the second group of the apertures are located in an outer zone encircling the central circular zone.

11. The in-situ chamber cleaning method of one of the claims 6 to 10, wherein the cleaning gas flow is ionized by a radio-frequency power.

12. A semiconductor process, comprising:
serially processing semiconductor wafers in a chamber and using a gas-distributing member inside the chamber to introduce a processing gas flow, wherein the gas-distributing member comprises a plurality of apertures;
conducting an in-situ chamber cleaning after processing a predetermined number of semiconductor wafers, said cleaning comprises using the gas-distributing member to introduce cleaning gas, wherein the in-situ chamber cleaning comprises:
(a) providing a cleaning gas flow through a first group of the apertures into the chamber while no cleaning gas is provided through the remaining second group of the apertures;
(b) providing a cleaning gas flow through the second group of the apertures into the chamber while no cleaning gas is provided through the first group of the apertures, wherein the cleaning gas comprises at least one of oxygen, nitrogen, hydrogen, CF₄, NF₃, SF₆, Cl₂, HBr, H₂O or CH₃OH; and
(c) ionizing each of the cleaning gas flows so as to employ ionized cleaning gas radicals to clean the chamber.

13. The semiconductor process of claim 12, wherein the in-situ chamber cleaning further comprises providing a cleaning gas flow through all the apertures into the chamber.

14. The semiconductor process of claim 13, wherein the cleaning gas comprises oxygen.

15. The semiconductor process of one of the claims 12 to 14, wherein the apertures are formed in a gas-distributing member, and wherein the gas-distributing member comprises a circular area, where the first group of the apertures is located in a central circular zone and the second group of the apertures is located in an outer zone encircling the central circular zone.
